# EUROPEAN PATENT APPLICATION

(11) **EP 4 704 519 A2**
(43) Date of publication of application: **04.03.2026**
(21) Application number: 25197909.2
(22) Date of filing: 25.08.2025
(51) Int. Cl.: H10D 62/10, H10D 30/60, H10D 62/13, H10D 30/00

(54) **HIGH VOLTAGE SEMICONDUCTOR DEVICES WITH OFFSET DRAIN**

(30) Priority: 26.08.2024 US 202418815414
(71) Applicant: Avago Technologies International Sales Pte. Limited, Singapore 768923 (SG)
(72) Inventor: Liu, Qing, Irvine, 92602 (US)
(74) Representative: Dilg, Haeusler, Schindelmann Patentanwaltsgesellschaft mbH

(57) **Abstract**

A semiconductor device (100) such as, for example, a gate-all-around field-effect transistor (GAAFET) device suitable for operability under higher operating voltage conditions (e.g., 1.2 volts to 3.3 volts). The semiconductor device (100) includes a first channel (112) that is formed in a first plane (200) of the semiconductor device (100), a second channel (114) that is formed in a second plane (300) of the semiconductor device (100) different from the first plane (200), a drain (150) that is formed around the first channel (112), a gate (132) that is formed around the second channel (114), and a source (142) that is formed around the second channel (114).

## Description

### BACKGROUND

The present disclosure relates, in general, to semiconductor fabrication technology. More particularly, the present disclosure relates to semiconductor device structures that can be used to provide a more diverse range of operating voltages for implementations of gate-all-around field-effect transistor (GAAFET) devices and other similar devices. For example, the semiconductor device structures described herein can be used in various implementations of laterally diffused metal-oxide-semiconductors (LDMOS) for use in a variety of different high-power applications such as power amplifiers, radio frequency (RF) amplifiers, and power transistors for radio and wireless communication systems. As the demand for high-power applications increases, research and development efforts continue to advance semiconductor technologies to meet manufacturing capabilities and capacities of foundries and enhance the functionality of various electronic devices and circuits.

### BRIEF DESCRIPTION OF THE DRAWINGS

FIG. 1 shows a top view illustrating components of an example semiconductor device, in accordance with some aspects of the disclosure
FIG. 2 shows a first cross section taken along a first plane of the semiconductor device of FIG. 1, in accordance with some aspects of the disclosure.
FIG. 3 shows a second cross section taken along a second plane of the semiconductor device of FIG. 1, in accordance with some aspects of the disclosure.
FIG. 4 shows a third cross section taken along a third plane of the semiconductor device of FIG. 1, in accordance with some aspects of the disclosure.

### DETAILED DESCRIPTION

In the following description, for the purposes of explanation, numerous details are set forth to provide a thorough understanding of the disclosure. It will be apparent to one skilled in the art, however, that other aspects can be practiced without some details. Different examples are described herein, and while various features are ascribed to the examples, it should be appreciated that the features described with respect to one example may be incorporated with other examples as well. By the same token, however, no single feature or features of any described example should be considered essential to every example, as other examples may omit such features.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

When an element is referred to herein as being "disposed" in some manner relative to another element (e.g., disposed on, disposed between, disposed under, disposed adjacent to, or disposed in some other relative manner), it is to be understood that the elements can be directly disposed relative to the other element (e.g., disposed directly on another element), or have intervening elements present between the elements. In contrast, when an element is referred to as being "disposed directly" relative to another element, it should be understood that no intervening elements are present in the "direct" example. However, the existence of a direct disposition does not exclude other examples in which intervening elements may be present.

Likewise, when an element is referred to herein as being a "layer", it is to be understood that the layer can be a single layer or include multiple layers. For example, a conductive layer can include multiple different conductive materials or multiple layers of different conductive materials, and a dielectric layer may comprise multiple dielectric materials or multiple layers of dielectric materials. When a layer is described as being coupled or connected to another layer, it is to be understood that the coupled or connected layers may include intervening elements present between the coupled or connected layers. In contrast, when a layer is referred to as being "directly" connected or coupled to another layer, it should be understood that no intervening elements are present between the layers. However, the existence of directly coupled or connected layers does not exclude other connections in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components.

Furthermore, unless otherwise indicated, all numbers used herein to express quantities, dimensions, and so forth should be understood as being modified in all instances by the term "about". In this application, the use of the singular includes the plural unless specifically stated otherwise, and use of the terms "and" and "or" means "and/or" unless otherwise indicated. Moreover, the use of the terms "including" and "having", as well as other forms, such as "includes", "included", "has", "have", and "had", should be considered non-exclusive. Also, terms such as "element" or "component" encompass both elements and components comprising one unit and elements and components that comprise more than one unit, unless specifically stated otherwise.

While some features and aspects have been described with respect to the examples, one skilled in the art will recognize that numerous modifications are possible. For example, the methods and processes described herein may be implemented using hardware components, custom integrated circuits (ICs), programmable logic, and/or any combination thereof. Further, while various methods and processes described herein may be described with respect to particular structural and/or functional components for ease of description, methods provided by various embodiments are not limited to any particular structural and/or functional architecture but instead can be implemented in any suitable hardware configuration. Similarly, while some functionality is ascribed to one or more system components, unless the context dictates otherwise, this functionality can be distributed among various other system components in accordance with the several embodiments.

Moreover, while the procedures of the methods and processes described herein are described in a particular order for ease of description, unless the context dictates otherwise, various procedures may be reordered, added, and/or omitted in accordance with various implementations. Moreover, the procedures described with respect to one method or process may be incorporated within other described methods or processes; likewise, system components described according to a particular structural architecture and/or with respect to one system may be organized in alternative structural architectures and/or incorporated within other described systems. Hence, while various examples are described with or without some features for ease of description and to illustrate aspects of those embodiments, the various components and/or features described herein with respect to a particular example can be substituted, added and/or subtracted from among other described embodiments, unless the context dictates otherwise. Consequently, although several examples are described above, it will be appreciated that the disclosure is intended to cover all modifications and equivalents within the scope of the following claims.

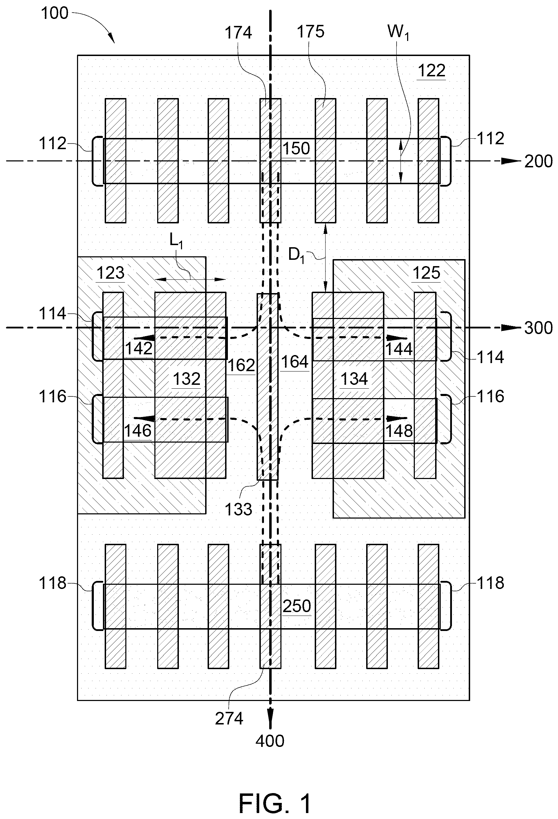

Referring to FIG. 1, a top view illustrating components of an example semiconductor device 100 is shown, in accordance with some aspects of the disclosure. The semiconductor device 100 can be implemented as a variety of types of semiconductor devices, such as various different types and combinations of transistor structures. For example, the semiconductor device 100 can include a non-planar (three-dimensional) GAAFET device, such as a gate all-around LDMOS device. As shown in FIG. 1, the semiconductor device 100 includes a channel 112, a channel 114, a channel 116, a channel 118, a well 122, a well 123, a well 125, a gate 132, a dummy gate 133, a gate 134, a source 142, a source 144, a source 146, a source 148, a drain 150, a drain 250, a trench 162, a trench 164, a dummy gate 174, a dummy gate 175, and a dummy gate 274. The channel 112, the channel 114, the channel 116, and the channel 118 can be implemented in various suitable manners. For example, the channel 112, the channel 114, the channel 116, and the channel 118 can each be implemented using one or more nanosheets to form one or more GAAFET devices.

The nanosheets can be formed using silicon and/or other suitable conductive materials, and the nanosheets can be generally rectangular structures that are anywhere from 10 nanometers to 50 nanometers wide and 3-7 nanometers thick, for example. The channel 112, the channel 114, the channel 116, and the channel 118 can also be implemented using one or more conductive channel structures other than nanosheets. For example, the channel 112, the channel 114, the channel 116, and the channel 118 can be implemented using conductive fins (e.g., silicon fins to form one or more fin field-effect transistor (FinFET) devices), one or more conductive nanowires (e.g., cylindrical silicon structures), and or other suitable channel types that may be used in various semiconductor fabrication processes. However, the use of nanosheets in particular to implement the channel 112, the channel 114, the channel 116, and the channel 118 can provide advantages especially for smaller node sizes (e.g., 3 nanometer processes, 2 nanometer processes, and below).

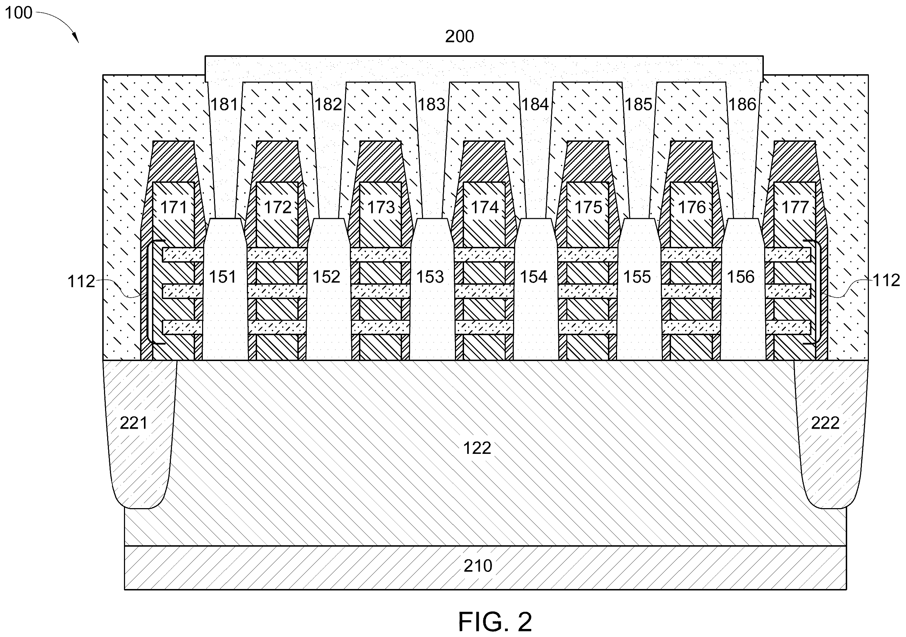

The semiconductor device 100 can generally be formed on a substrate 210 (as shown in FIGS. 2-4). The substrate 210 can be formed using silicon material (e.g., crystalline silicon) and/or other suitable materials or combinations of materials. The substrate 210 can be implemented using various fabrication technologies, such as using a silicon-on-insulator (SOI) structure, a bulk semiconductor structure, an alloy semiconductor, a compound semiconductor, germanium, and/or various other suitable materials and combinations thereof. The substrate 210 generally provides a base for forming components of the semiconductor device 100 thereon. The semiconductor device 100 can be implemented in a variety of types of circuits, inducing various types of integrated circuit (IC) chips.

The well 122, the well 123, and the well 125 can be formed at least partially within the substrate 210. The well 122, the well 123, and the well 125 can also be formed at least partially separate from the substrate 210, for example at least partially within various types of oxide layers and/or other insulating/dielectric layers within the semiconductor device 100. The well 122 can be relatively lightly doped using a first dopant, whereas the well 123 and the well 125 can be relatively lightly doped using a second dopant that is different from the first dopant. For an NLDMOS implementation of the semiconductor device 100, the first dopant can be an n-type dopant (and the well 122 can accordingly be an n-type well), and the second dopant can be a p-type dopant (and the well 124 can accordingly be a p-type well). In contrast, for a PLDMOS implementation of the semiconductor device 100, the first dopant can be a p-type dopant (and the well 122 can accordingly be a p-type well), and the second dopant can be an n-type dopant (and the well 124 can accordingly be an n-type well). Various suitable n-type dopants can be used to form the well 122, the well 123, and/or the well 125, including arsenic, phosphorous, and/or other similar n-type dopants, for example. Various suitable p-type dopants can also be used to form the well 122, the well 123, and/or the well 125, including boron and/or other similar p-type dopants, for example.

The gate 132 can be formed around the channel 114 and around the channel 116. In a GAAFET implementation, the gate 132 can be formed around the channel 114 and around the channel 116 such that the gate 132 surrounds the channel 114 and surrounds the channel 116 on all sides. The gate 132 can be formed using polysilicon material (e.g., to provide a high-k gate) and/or another suitable materials or combination of materials (e.g., a metal gate) depending on the intended application. Voltage applied at the gate 132 can generally control the operation and conductance of the semiconductor device 100 by controlling the operation and conductance of the channel 114 and the channel 116. Various types of spacers can be formed at least partially around the gate 132 to electrically isolate the gate 132 and prevent charge leakage. For example, the spacers can include materials with high dielectric constants such as silicon nitride, silicon oxide, and/or other suitable materials and combinations thereof. Additionally, one or more gate oxide layers can be formed between the gate 132 and the channel 114 and between the gate 132 and the channel 116 using materials such as silicon nitride, aluminum oxide, silicon dioxide, and/or other suitable materials and combinations thereof, for example. The gate 132 can be formed around the channel 114 and around the channel 116 in a variety of ways. For example, the gate 132 can completely surround the channel 114 and the channel 116, or the gate 132 can partially surround the channel 114 and the channel 116 (e.g., gaps can exist between the channel 114 and the gate 132 and/or between the channel 116 and the gate 132).

Similarly, the gate 134 can be formed around the channel 114 and around the channel 116. In a GAAFET implementation, the gate 134 can be formed around the channel 114 and around the channel 116 such that the gate 134 surrounds the channel 114 and surrounds the channel 116 on all sides. The gate 134 can be formed using polysilicon material (e.g., to provide a high-k gate) and/or another suitable materials or combination of materials (e.g., a metal gate) depending on the intended application. Voltage applied at the gate 134 can generally control the operation and conductance of the semiconductor device 100 by controlling the operation and conductance of the channel 114 and the channel 116. Various types of spacers can be formed at least partially around the gate 134 to electrically isolate the gate 134 and prevent charge leakage. For example, the spacers can include materials with high dielectric constants such as silicon nitride, silicon oxide, and/or other suitable materials and combinations thereof. Additionally, one or more gate oxide layers can be formed between the gate 134 and the channel 114 and between the gate 134 and the channel 116 using materials such as silicon nitride, aluminum oxide, silicon dioxide, and/or other suitable materials and combinations thereof, for example. The gate 134 can be formed around the channel 114 and around the channel 116 in a variety of ways. For example, the gate 134 can completely surround the channel 114 and the channel 116, or the gate 134 can partially surround the channel 114 and the channel 116 (e.g., gaps can exist between the channel 114 and the gate 134 and/or between the channel 116 and the gate 134).

The source 142, the source 144, the source 146, and the source 148 can be implemented at least in part as epitaxial layers formed around the channel 114 and the channel 116, respectively. For example, the source 142 can be implemented at least in part using a relatively highly doped epitaxial layer that is formed around the channel 114 and adjacent to the gate 132, the source 144 can be implemented at least in part using a relatively highly doped epitaxial layer that is formed around the channel 114 and adjacent to the gate 134, the source 146 can be implemented at least in part using a relatively highly doped epitaxial layer that is formed around the channel 116 and adjacent to the gate 132, and source 148 can be implemented at least in part using a relatively highly doped epitaxial layer that is formed around the channel 116 and adjacent to the gate 134. While the source 142, the source 144, the source 146, and the source 148 can be formed generally adjacent to the gate 132 and the gate 134, respectively, this adjacency may not be direct in that various spacer layers (e.g., silicon nitride, silicon oxide, etc.) can be disposed between the source 142, the source 144, the source 146, the source 148, the gate 132, and the gate 134, respectively.

The source 142, the source 144, the source 146, and the source 148 can be formed around the channel 114 and the channel 116, respectively, in a variety of ways. For example, the source 142, the source 144, the source 146, and the source 148 can completely surround the channel 114 and the channel 116, respectively, or the source 142, the source 144, the source 146, and the source 148 can partially surround the channel 114 and the channel 116 (e.g., gaps can exist between), respectively. Additionally, the semiconductor device 100 can include various types of spacer layers (e.g., silicon nitride, silicon oxide, etc.) that are disposed between the source 142, the source 144, the source 146, the source 148, the channel 114, and the channel 116, respectively. The epitaxial material that can be used to form the source 142, the source 144, the source 146, and the source 148 can include various suitable material such as, for example, silicon, gallium arsenide, and/or other suitable epitaxial materials and combinations thereof.

The epitaxial material that can be used to form the source 142, the source 144, the source 146, and the source 148 can be highly doped using suitable n-type dopants (e.g., for an NLDMOS implementation of the semiconductor device 100) or suitable p-type dopants (e.g., for a PLDMOS implementation of the semiconductor device 100). The well 122, the well 123, and the well 125 can be doped in accordance with a first doping concentration, the epitaxial material that can be used to form the source 142, the source 144, the source 146, and the source 148 can be doped in accordance with a second doping concentration, and the second doping concentration can be greater than the first doping concentration. The source 142, the source 144, the source 146, and the source 148 can be formed in accordance with a raised source/drain (RSD) structure having advantageous electrical properties for electrostatic discharge prevention, for example.

The drain 150 and the drain 250 can be implemented at least in part using epitaxial layers that are formed around the channel 112 and the channel 118, respectively. For example, the drain 150 can be implemented at least in part using relatively highly doped epitaxial layers that are formed around the channel 112, and the drain 250 can be implemented at least in part using relatively highly doped epitaxial layers that are formed around the channel 118. The drain 150 and the drain 250 can be formed around the channel 112 and the channel 118, respectively, in a variety of ways. For example, the drain 150 and the drain 250 can completely surround the channel 112 and the channel 118, respectively, or the drain 150 and the drain 250 can partially surround the channel 112 and the channel 118 (e.g., gaps can exist between), respectively. Additionally, the semiconductor device 100 can include various types of spacer layers (e.g., silicon nitride, silicon oxide, etc.) that are disposed between the drain 150 and the drain 250, the channel 112, and the channel 118, respectively.

The epitaxial material that can be used to form the drain 150 and the drain 250 can include various suitable material such as, for example, silicon, gallium arsenide, and/or other suitable epitaxial materials and combinations thereof. The epitaxial material that can be used to form the drain 150 and the drain 250 can be highly doped using suitable n-type dopants (e.g., for an NLDMOS implementation of the semiconductor device 100) or suitable p-type dopants (e.g., for a PLDMOS implementation of the semiconductor device 100). The well 122, the well 123, and the well 125 can be doped in accordance with a first doping concentration, the epitaxial material that can be used to form the drain 150 and the drain 250 can be doped in accordance with a third doping concentration, and the third doping concentration can then be greater than the first doping concentration. The drain 150 and the drain 250 can again be formed in accordance with a raised source/drain (RSD) structure having advantageous electrical properties for electrostatic discharge prevention, for example.

In the top view of the semiconductor device 100 as shown in FIG. 1, three separate planes are shown: a plane 200, a plane 300, and a plane 400. From the perspective shown in FIG. 1, the plane 200 and the plane 300 are horizontal planes, and the plane 400 is a vertical plane. As shown, the channel 112 is formed in the plane 200 (e.g., a first plane) whereas the channel 114 is formed in the plane 300 (e.g., a second plane). Accordingly, since the drain 150 can be formed around the channel 112 (without being formed around the channel 114), and the source 142, the gate 132, the gate 134, and the source 144 can be formed around the channel 114 (without being formed around the channel 112), the drain 150 can be formed in a separate plane from the source 142, the gate 132, the gate 134, and the source 144 such that the drain 150 is offset from the source 142, the gate 132, the gate 134, and the source 144. This specific structure of the semiconductor device 100 can be particularly advantageous for high voltage applications. In some alternative structures where the source, gate, and drain are all formed in a common plane, operating voltages exceeding about 0.75 volts can cause deterioration in performance and, in some cases, component damage or failure (e.g., the gate may fail under higher operating voltages). However, the use of a separate plane for the drain 150 in the semiconductor device 100 can allow for operating voltages in the range of 1.2 volts to 3.3 volts.

As illustrated in FIG. 1, during operation of an embodiment of the semiconductor device 100, current can flow from the drain 150 to the source 142 (as controlled by the gate 132) and from the drain 150 to the source 144 (as controlled by the gate 134). Similarly, current can flow from the drain 250 to the source 146 (as controlled by the gate 132) and from the drain 250 to the source 148 (as controlled by the gate 134). By forming the drain 150 in the plane 200 as opposed to the plane 300, the area of the drain 150 can be significantly increased, and thus (i) the resistance of the drain 150 can be reduced, (ii) the on resistance (Rₒₙ) of the semiconductor device 100 can be improved, and (iii) the drive current of the semiconductor device 100 can be improved. Accordingly, when higher operating voltages (e.g., 1.2 volts to 3.3 volts) are applied to the drain 150, the semiconductor device 100 can operate without deterioration (e.g., when current reaches the gate 132 and the gate 134 from the drain 150, deterioration of the gate 132 and the gate 134 may not occur). Additionally, the semiconductor device 100 can be implemented using GAAFET technology with very small node sizes (3 nanometers and below) to maintain a compact footprint while also providing operability at high voltages. Moreover, the structure of the semiconductor device 100 can be implemented without significantly altering the fabrication process because it does not require any additional processing steps or mask layers.

FIG. 1 also shows some example dimensions associated with the semiconductor device 100. The length L₁ as shown generally represents the length of the gate 132 as measured in the direction along the plane 300 (e.g., from an end of the gate 132 closest to the source 142 to an end of the gate 132 closest to the trench 162). The length L₁ can be between 65 nanometers and 310 nanometers in some examples. Next, the distance D₁ as shown generally represents the distance between the dummy gate 175 formed around the channel 112 and the gate 134 (e.g., the distance between an end of the dummy gate 175 closest to the gate 134 and an end of the gate 134 closest to the dummy gate 175). The distance D₁ can be between 15 nanometers and 105 nanometers in some examples. Finally, the width W₁ as shown generally represents the width of the drain 150 as measured in a direction perpendicular to the plane 200 (e.g., from an end of the drain 150 furthest from the gate 134 to an end of the drain 150 closest to the gate 134). The width W₁ can be between 20 nanometers and 55 nanometers in some examples. These specific dimensions can provide advantages in terms of facilitating proper operation of the semiconductor device 100 under higher operating voltage conditions. For example, these specific dimensions can provide advantages by allowing higher voltages (e.g., 1.2 volts to 3.3 volts) to be applied to the drain 150 without causing damage to any of the components of the semiconductor device 100 and without causing various types of performance deterioration for the semiconductor device 100.

Referring to FIG. 2, a cross section of the semiconductor device 100 taken along the plane 200 is shown, in accordance with some aspects of the disclosure. Accordingly, the cross section shown in FIG. 2 illustrates the drain 150 in more detail. From the cross section shown in FIG. 2, the substrate 210 can be seen, along with the channel 112, the dummy gate 174, the dummy gate 175, and the well 122. Also shown in the cross section of FIG. 2 are various additional components of the semiconductor device 100, including an epitaxial layer 151, an epitaxial layer 152, an epitaxial layer 154, an epitaxial layer 155, an epitaxial layer 156, a dummy gate 171, a dummy gate 172, a dummy gate 173, a dummy gate 176, a dummy gate 177, an interconnect 181, an interconnect 182, an interconnect 183, an interconnect 184, an interconnect 185, an interconnect 186, an isolation structure 221, and an isolation structure 222. As shown in the example cross section of FIG. 2, the channel 112 is implemented using three separate nanosheets.

One or more of the epitaxial layer 151, the epitaxial layer 152, the epitaxial layer 153, the epitaxial layer 154, the epitaxial layer 155, and/or the epitaxial layer 156 can cooperatively form the gate 150. The epitaxial layer 151, the epitaxial layer 152, the epitaxial layer 153, the epitaxial layer 154, the epitaxial layer 155, and the epitaxial layer 156 can be formed using various suitable materials such as, for example, silicon, gallium arsenide, and/or other suitable epitaxial materials and combinations thereof. The epitaxial layer 151, the epitaxial layer 152, the epitaxial layer 153, the epitaxial layer 154, the epitaxial layer 155, and the epitaxial layer 156 can be highly doped using n-type dopants or p-type dopants. The well 122 can be doped in accordance with a first doping concentration, the epitaxial layer 151, the epitaxial layer 152, the epitaxial layer 153, the epitaxial layer 154, the epitaxial layer 155, and the epitaxial layer 156 can be doped in accordance with a third doping concentration, and the third doping concentration can then be greater than the first doping concentration. Since the drain 150 can be formed around the channel 112 that is formed in the plane 200 as opposed to the channel 114 that is formed in the plane 300, the drain 150 can be implemented using one or more of the epitaxial layer 151, the epitaxial layer 152, the epitaxial layer 153, the epitaxial layer 154, the epitaxial layer 155, and/or the epitaxial layer 156, and thus the area of the drain 150 can be increased relative to some alternative structures. Notably, the drain 150 can be disposed over the well 122 without being disposed over the well 123 or the well 125.

The dummy gate 171, the dummy gate 172, the dummy gate 173, the dummy gate 174, the dummy gate 175, the dummy gate 176, and the dummy gate 177 can be formed around the channel 112 such that, in a GAAFET implementation, the dummy gate 171, the dummy gate 172, the dummy gate 173, the dummy gate 174, the dummy gate 175, the dummy gate 176, and the dummy gate 177 surround the channel 112 on all sides. The dummy gate 171, the dummy gate 172, the dummy gate 173, the dummy gate 174, the dummy gate 175, the dummy gate 176, and the dummy gate 177 can be formed using polysilicon material and/or another suitable materials. Various types of spacers can be formed at least partially around the dummy gate 171, the dummy gate 172, the dummy gate 173, the dummy gate 174, the dummy gate 175, the dummy gate 176, and the dummy gate 177. Additionally, one or more gate oxide layers can be formed between the dummy gate 171, the dummy gate 172, the dummy gate 173, the dummy gate 174, the dummy gate 175, the dummy gate 176, and the dummy gate 177 and the channel 112.

The dummy gate 171, the dummy gate 172, the dummy gate 173, the dummy gate 174, the dummy gate 175, the dummy gate 176, and the dummy gate 177 can be formed around the channel 112 in a variety of ways. For example, the dummy gate 171, the dummy gate 172, the dummy gate 173, the dummy gate 174, the dummy gate 175, the dummy gate 176, and the dummy gate 177 can completely surround the channel 112, or the dummy gate 171, the dummy gate 172, the dummy gate 173, the dummy gate 174, the dummy gate 175, the dummy gate 176, and the dummy gate 177 can partially surround the channel 112 (e.g., gaps can exist between the channel 112 and the dummy gate 171, the dummy gate 172, the dummy gate 173, the dummy gate 174, the dummy gate 175, the dummy gate 176, and the dummy gate 177). The dummy gate 171, the dummy gate 172, the dummy gate 173, the dummy gate 174, the dummy gate 175, the dummy gate 176, and the dummy gate 177 are "dummy gates" in the sense that they do not operate as active gates within the semiconductor device 100 (unlike the gate 132 and the gate 134). As shown in FIG. 2, the semiconductor device 100 may not include interconnects connected to the dummy gate 171, the dummy gate 172, the dummy gate 173, the dummy gate 174, the dummy gate 175, the dummy gate 176, and the dummy gate 177.

The interconnect 181, the interconnect 182, the interconnect 183, the interconnect 184, the interconnect 185, and the interconnect 186 can be implemented using any suitable structure used to form electrical connections between components of the semiconductor device 100 and/or components of a circuit (e.g., an IC) including the semiconductor device 100. For example, the interconnect 181, the interconnect 182, the interconnect 183, the interconnect 184, the interconnect 185, and the interconnect 186 can be implemented as conductive copper vias, among other possible types of interconnect structures. The interconnect 181 can be used to form an electrical connection between the epitaxial layer 151 and one or more additional components of the semiconductor device 100 and/or components of a circuit including the semiconductor device 100. The interconnect 182 can be used to form an electrical connection between the epitaxial layer 152 and one or more additional components of the semiconductor device 100 and/or components of a circuit including the semiconductor device 100.

The interconnect 183 can be used to form an electrical connection between the epitaxial layer 153 and one or more additional components of the semiconductor device 100 and/or components of a circuit including the semiconductor device 100. The interconnect 184 can be used to form an electrical connection between the epitaxial layer 154 and one or more additional components of the semiconductor device 100 and/or components of a circuit including the semiconductor device 100. The interconnect 185 can be used to form an electrical connection between the epitaxial layer 155 and one or more additional components of the semiconductor device 100 and/or components of a circuit including the semiconductor device 100. Finally, the interconnect 186 can be used to form an electrical connection between the epitaxial layer 156 and one or more additional components of the semiconductor device 100 and/or components of a circuit including the semiconductor device 100. The structure of the drain 250 can be similar to or identical to the structure of the drain 150 as shown in FIG. 2.

The isolation structure 221 and the isolation structure 222 can be implemented as shallow trench isolation (STI) structures, for example. Accordingly, the isolation structure 221 and the isolation structure 222 can be formed as a result of etching trenches in the semiconductor device 100. For example, after etching a first trench, the isolation structure 221 can be formed by depositing a dielectric material at least partially within the first trench. After etching a second trench, the isolation structure 222 can be formed by depositing a dielectric material at least partially within the second trench. The dielectric material used to form the isolation structure 221 and the isolation structure 222 can be, for example, silicon oxide, silicon nitride, and/or other suitable materials and combinations of materials. The isolation structure 221 and the isolation structure 222 can generally prevent leakage of electric current between different components of the semiconductor device 100.

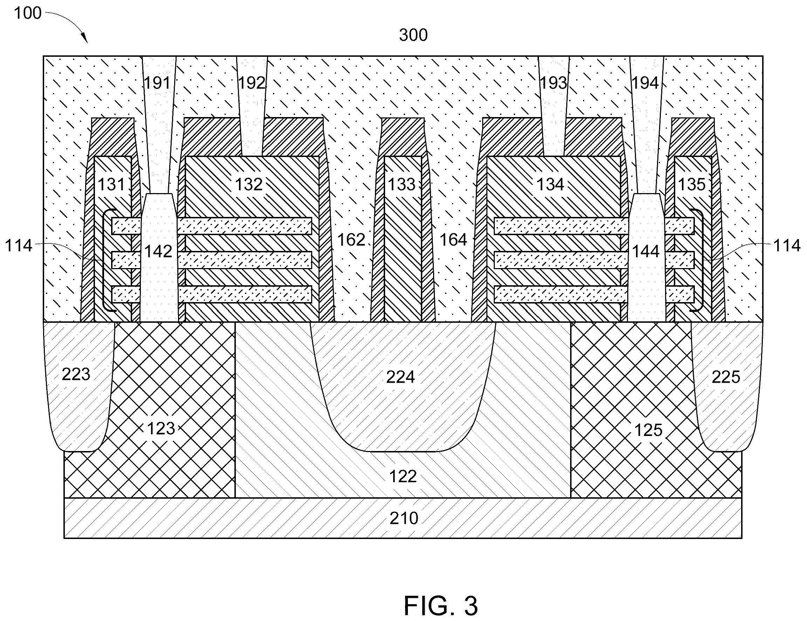

Referring to FIG. 3, a cross section of the semiconductor device 100 taken along the plane 300 is shown, in accordance with some aspects of the disclosure. From the cross section shown in FIG. 3, the source 142, the gate 132, the dummy gate 133, the gate 134, the source 144, the trench 162, the trench 164, the substrate 210, the well 122, the well 123, and the well 125 can be seen. Also shown in the cross section of FIG. 3 are various additional components of the semiconductor device 100, including a dummy gate 131, a dummy gate 135, an isolation structure 223, an isolation structure 224, an isolation structure 225, an interconnect 191, an interconnect 192, an interconnect 193, and an interconnect 194. Notably, as shown in FIG. 3, the source 142 is disposed over the well 123 without being disposed over the well 122, the source 144 is disposed over the well 125 without being disposed over the well 122, the gate 132 is disposed over both the well 122 and the well 123, and the gate 134 is disposed over both the well 122 and the well 125. As shown in the example cross section of FIG. 3, the channel 114 is implemented using three separate nanosheets.

The dummy gate 131 and the dummy gate 135 can be formed around the channel 114 such that, in a GAAFET implementation, the dummy gate 131 and the dummy gate 135 surround the channel 114 on all sides. Various types of spacers can be formed at least partially around the dummy gate 131 and the dummy gate 135. Additionally, one or more gate oxide layers can be formed between the dummy gate 131 and the dummy gate 135 and the channel 114. The dummy gate 131 and the dummy gate 135 can be formed around the channel 114 in a variety of ways. For example, the dummy gate 131 and the dummy gate 135 can completely surround the channel 114, or the dummy gate 131 and the dummy gate 135 can partially surround the channel 114 (e.g., gaps can exist between the channel 114 and the dummy gate 131 and the dummy gate 135).

The dummy gate 133 can be similar to the dummy gate 131 and the dummy gate 135 except that the dummy gate 133 can be formed between the trench 162 and the trench 164 as opposed to being formed around the channel 114. However, in some examples, the dummy gate 133 can also be formed around the channel 114 in a similar manner to the dummy gate 131 and the dummy gate 135 (e.g., the trench 162 and the trench 164 can be etched after the dummy gate 133 is formed around the channel 114). As shown, the trench 162 can be disposed between the gate 132 and the dummy gate 133, and the trench 164 can be disposed between the dummy gate 133 and the gate 134. The dummy gate 131, the dummy gate 133, and the dummy gate 135 are "dummy gates" in the sense that they do not operate as active gates within the semiconductor device 100 (unlike the gate 132 and the gate 134). As shown in FIG. 3, the semiconductor device 100 may not include interconnects connected to the dummy gate 131, the dummy gate 133, and the dummy gate 135. The dummy gate 131, the dummy gate 133, and the dummy gate 135 can be formed using polysilicon material and/or another suitable materials.

The interconnect 191, the interconnect 192, the interconnect 193, and the interconnect 194 can be implemented using any suitable structure used to form electrical connections between components of the semiconductor device 100 and/or components of a circuit (e.g., an IC) including the semiconductor device 100. For example, the interconnect 191, the interconnect 192, the interconnect 193, and the interconnect 194 can be conductive copper vias, among other possible types of interconnect structures. The interconnect 191 can be used to form an electrical connection between the source 142 and one or more additional components of the semiconductor device 100 and/or components of a circuit including the semiconductor device 100. The interconnect 192 can be used to form an electrical connection between the gate 132 and one or more additional components of the semiconductor device 100 and/or components of a circuit including the semiconductor device 100. The interconnect 193 can be used to form an electrical connection between the gate 134 and one or more additional components of the semiconductor device 100 and/or components of a circuit including the semiconductor device 100. Finally, the interconnect 194 can be used to form an electrical connection between the source 144 and one or more additional components of the semiconductor device 100 and/or components of a circuit including the semiconductor device 100.

The isolation structure 223, the isolation structure 224, and the isolation structure 225 can be implemented as STI structures, for example. Accordingly, the isolation structure 223, the isolation structure 224, and the isolation structure 225 can be formed as a result of etching trenches in the semiconductor device 100. For example, after etching a third trench, the isolation structure 223 can be formed by depositing a dielectric material at least partially within the third trench. After etching a fourth trench, the isolation structure 224 can be formed by depositing a dielectric material at least partially within the fourth trench. After etching a fifth trench, the isolation structure 225 can be formed by depositing a dielectric material at least partially within the fifth trench. The dielectric material used to form the isolation structure 223, the isolation structure 224, and the isolation structure 225 can be, for example, silicon oxide, silicon nitride, and/or other suitable materials and combinations of materials. The isolation structure 223, the isolation structure 224, and the isolation structure 225 can generally prevent leakage of electric current between different components of the semiconductor device 100.

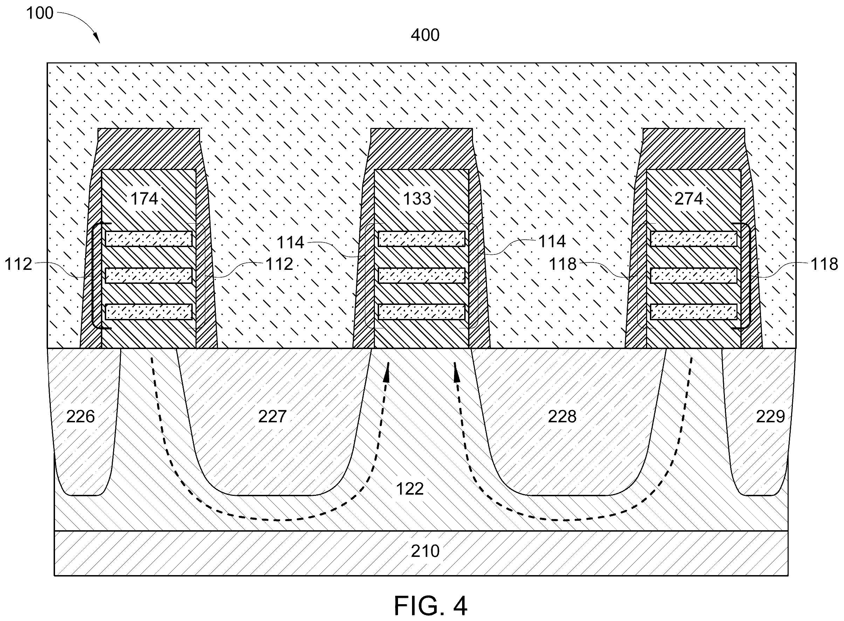

Referring to FIG. 4, a cross section of the semiconductor device 100 taken along the plane 400 is shown, in accordance with some aspects of the disclosure. From the cross section shown in FIG. 4, the channel 112, the channel 114, the channel 118, the dummy gate 174, the dummy gate 133, the dummy gate 274, the well 122, and the substrate 210 can be seen. Also shown in the cross section of FIG. 4 are various additional components of the semiconductor device 100, including an isolation structure 226, an isolation structure 227, an isolation structure 228, and an isolation structure 229. The isolation structure 227 can generally be disposed in the well 122 and between the drain 150 and the gate 132 and the gate 134, and the isolation structure 228 can generally be disposed in the well 122 and between the drain 250 and the gate 132 and the gate 134. As shown in the example cross section of FIG. 4, the channel 112, the channel 114, and the channel 118 are each implemented using three separate nanosheets.

Additionally, as shown, during operation of an embodiment of the semiconductor device 100, current flows from the dummy gate 174 (e.g., via the drain 150 as shown in FIG. 1) under the isolation structure 227 and to the dummy gate 133 (and to the source 142 as controlled by the gate 132, and to the source 144 as controlled by the gate 134, as shown in FIG. 1). Also, as shown, during operation of the semiconductor device 100, current flows from the dummy gate 274 (via the drain 250 as shown in FIG. 1) under the isolation structure 228 and to the dummy gate 133 (and to the source 146 as controlled by the gate 132, and to the source 148 as controlled by the gate 134, as shown in FIG. 1). This extended path for current to flow from the drain 150 and the drain 250 to the source 142, the source 144, the source 146, and the source 148, respectively, can help provide the extended operability of semiconductor device 100 under higher operating voltage conditions when compared to some alternate structures with a shorter path for current flow.

The isolation structure 226, the isolation structure 227, the isolation structure 228, and the isolation structure 229 can again be implemented as STI structures, for example. Accordingly, the isolation structure 226, the isolation structure 227, the isolation structure 228, and the isolation structure 229 can be formed as a result of etching trenches in the semiconductor device 100. For example, after etching a sixth trench, the isolation structure 226 can be formed by depositing a dielectric material at least partially within the sixth trench. After etching a seventh trench, the isolation structure 227 can be formed by depositing a dielectric material at least partially within the seventh trench. After etching an eighth trench, the isolation structure 228 can be formed by depositing a dielectric material at least partially within the eighth trench. After etching a ninth trench, the isolation structure 229 can be formed by depositing a dielectric material at least partially within the ninth trench. Again, the dielectric material used to form the isolation structure 226, the isolation structure 227, the isolation structure 228, and the isolation structure 229 can be, for example, silicon oxide, silicon nitride, and/or other suitable materials and combinations of materials. The isolation structure 226, the isolation structure 227, the isolation structure 228, and the isolation structure 229 can generally prevent leakage of electric current between different components of the semiconductor device 100.

## Claims

1. A semiconductor device (100), comprising:
a first channel (112) formed in a first plane (200) of the semiconductor device (100);
a second channel (114) formed in a second plane (300) of the semiconductor device (100) that is different from the first plane (200);
a drain (150) formed around the first channel (112);
a gate (132) formed around the second channel (114); and
a source (142) formed around the second channel (114).

2. The semiconductor device (100) of claim 1, comprising a dummy gate formed around the first channel (112), wherein a distance between the dummy gate formed around the first channel (112) and the gate (132) formed around the second channel (114) is between 15 and 105 nanometers.

3. The semiconductor device (100) of claim 1 or 2, wherein the drain (150) is disposed over an n-type well and the source (142) is disposed over a p-type well.

4. The semiconductor device (100) of claim 3, wherein the gate (132) is disposed over the n-type well and over the p-type well.

5. The semiconductor device (100) of any of the claims 1 to 4, comprising:
a second gate (134) formed around the second channel (114); and
a second source (144) formed around the second channel (114);
wherein, during operation of the semiconductor device (100), current flows from the drain (150) to the source (142) and from the drain (150) to the second source (144).

6. The semiconductor device (100) of claim 5, comprising a dummy gate disposed between the gate (132) and the second gate (134).

7. The semiconductor device (100) of claim 6, comprising:
a first trench (162) disposed between the gate (132) and the dummy gate; and
a second trench (164) disposed between the second gate (134) and the dummy gate.

8. The semiconductor device (100) of any of the claims 1 to 7, wherein a length of the gate (132) as measured along the second plane (300) is between 65 nanometers and 310 nanometers.

9. The semiconductor device (100) of any of the claims 1 to 8, wherein a width of the drain (150) as measured in a direction perpendicular to the first plane (200) is between 20 nanometers and 55 nanometers.

10. A semiconductor device (100), comprising:
a first channel (112) formed in a first plane (200) of the semiconductor device (100);
a second channel (114) formed in a second plane (300) of the semiconductor device (100) that is different from the first plane (200);
a drain (150) formed around the first channel (112);
a first gate (132) formed around the second channel (114);
a first source (142) formed around the second channel (114) and adjacent to the first gate (132);
a second gate (134) formed around the second channel (114); and
a second source (144) formed around the second channel (114) and adjacent to the second gate (134).

11. The semiconductor device (100) of claim 10, wherein, during operation of the semiconductor device (100), current flows from the drain (150) to the first source (142) and from the drain (150) to the second source (144).

12. The semiconductor device (100) of claim 10 or 11, comprising at least one of the following features:
comprising:
a dummy gate disposed between the first gate (132) and the second gate (134);
a first trench (162) disposed between the first gate (132) and the dummy gate; and
a second trench (164) disposed between the second gate (134) and the dummy gate;
wherein:
the drain (150) is disposed over an n-type well;
the first source (142) is disposed over a p-type well; and
the first gate (132) is disposed over the n-type well and over the p-type well.

13. The semiconductor device (100) of any of the claims 10 to 12, wherein the drain (150) comprises:
a first epitaxial layer (151) disposed between a first dummy gate and a second dummy gate; and
a second epitaxial layer (152) disposed between the second dummy gate and a third dummy gate;
in particular wherein a distance between the second dummy gate and the second gate (134) is between 15 and 105 nanometers.

14. A semiconductor device (100), comprising:
a substrate (210) comprising a first well (122) and a second well (123), the first well (122) doped with a first dopant and the second well (123) doped with a second dopant that is different from the first dopant;
a first channel (112) formed in a first plane (200) of the semiconductor device (100);
a second channel (114) formed in a second plane (300) of the semiconductor device (100) that is different from the first plane (200);
a drain (150) formed around the first channel (112) and disposed over the first well (122);
a gate (132) formed around the second channel (114); and
a source (142) formed around the second channel (114) and disposed over the second well (123).

15. The semiconductor device (100) of claim 14, comprising at least one of the following features:
comprising a dummy gate formed around the first channel (112), wherein a distance between the dummy gate formed around the first channel (112) and the gate (132) formed around the second channel (114) is between 15 and 105 nanometers;
wherein:
the first dopant comprises a p-type dopant; and
the second dopant comprises an n-type dopant;
wherein:
a length of the gate (132) as measured along the second plane (300) is between 65 nanometers and 310 nanometers; and
a width of the drain (150) as measured in a direction perpendicular to the first plane (200) is between 20 nanometers and 55 nanometers;
wherein the drain (150) comprises:
a first epitaxial layer (151) disposed between a first dummy gate and a second dummy gate; and
a second epitaxial layer (152) disposed between the second dummy gate and a third dummy gate.
